(19) Europäisches Patentamt / European Patent Office / Office européen des brevets

(11) **EP 4 704 341 A1**

(12) **EUROPEAN PATENT APPLICATION**

(43) Date of publication:
04.03.2026 Bulletin 2026/10

(21) Application number: 24196553.2

(22) Date of filing: 26.08.2024

(51) International Patent Classification (IPC):
*H03H 9/02* (2006.01)   *H03H 9/13* (2006.01)
*H03H 9/17* (2006.01)   *H03H 3/02* (2006.01)

(52) Cooperative Patent Classification (CPC):
**H03H 9/175; H03H 9/02275; H03H 9/02834;**
**H03H 9/132;** H03H 9/02559; H03H 2003/025

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **Ecole Polytechnique Fédérale de Lausanne (EPFL)**
**1015 Lausanne (CH)**

(72) Inventors:
• **Stettler, Silvan**
  **1025 St-Sulpice (CH)**
• **Villanueva T., Guillermo Luis**
  **1025 St-Sulpice (CH)**

(74) Representative: **Vesterinen, Jussi Tapio**
**LUMI IP GmbH**
**Rodtmattstrasse 45**
**3014 Bern (CH)**

(54) **SUSPENDED ACOUSTIC WAVE RESONATOR COMPRISING BURIED ELECTRODES**

(57)     An acoustic wave resonator (1) according to the present invention comprises: a base substrate (10); a piezoelectric substrate (2) placed on top of the base substrate (10) such that the piezoelectric substrate (2) has a suspended portion above the base substrate (10); a set of electrodes buried in the suspended portion of the piezoelectric substrate (2) and forming an interdigital transducer (4), the electrodes cross-sectionally extending in the piezoelectric substrate (2) between an upper surface and a lower surface of the piezoelectric substrate (2) in a thickness direction of the piezoelectric substrate (2); and a set of electrical contact elements ($5_1$, $5_2$) connected to the interdigital transducer (4). The electrodes only partially span through the piezoelectric substrate (2) in the thickness direction of the piezoelectric substrate (2).

Fig. 1

EP 4 704 341 A1

## Description

### TECHNICAL FIELD

The present invention relates to an acoustic wave resonator, and in particular to a suspended piezoelectric resonator with buried electrodes. In one embodiment, the piezoelectric resonator comprises a suspended lithium niobate film with electrodes buried therein. The present invention also relates to a filter device comprising one or more acoustic wave resonators, and to a method for fabricating the acoustic wave resonator.

### BACKGROUND OF THE INVENTION

The fifth generation of wireless communication technology, commonly referred to as 5G, promises unprecedented advancements in data transfer rates, network capacity, and connectivity. Among the various frequency bands allocated for 5G new radio (NR) deployment, the sub-6 GHz range (5G Frequency Range 1, 5G-FR1) stands out as a crucial spectrum range for large area coverage. The 5G NR mid-band spectrum (1-6 GHz) strikes a good balance between capacity and coverage and is particularly suited for enabling high-speed mobile broadband services covering urban and sub-urban areas. One of the key factors for the enhancement of data rates compared to 4G long term evolution (LTE) is the increased bandwidth available with the new 5G NR bands. For instance, the spectrum allocation for 5G-FR1 introduced the n77 (3.3 - 4.2 GHz), n78 (3.3 - 3.8 GHz), and n79 (4.4 - 5.0 GHz) bands with extremely large fractional bandwidth (FBW) as high as 24% (n77 band). The combination of higher frequencies and expanded bandwidths results in increasingly demanding requirements for radio frequency (RF) filter hardware in the RF front end (RFFE) based on surface acoustic wave (SAW) and bulk acoustic wave (BAW) resonators.

These challenges have motivated significant advances in SAW and BAW technology. Replacing aluminium nitride (AlN) with scandium-doped aluminium nitride (AlScN) has boosted effective electromechanical coupling $k_{eff}^2$ for commercial BAW devices enabled by the higher $d_{33}$ coefficient of AlScN. The resonance frequency $f_s$ of AlScN-based BAW resonators is defined by the film thickness, thus frequencies above 3 GHz can readily be attained with sufficient quality factor Q. In the 1-8 GHz range, filter technology based on thin film bulk acoustic resonators (FBARs) or resonators using a solidly mounted piezoelectric film (SMR) of AlScN has been commercially successful. Yet, the moderate $k_{eff}^2$ of AlScN and limited frequency tunability complicate the implementation of BAW-based filters for the wide-FBW n77-79 bands. In contrast, SAW devices benefit from lithographically defined $f_s$ by changing the acoustic wavelength $\lambda$ with the electrode pitch of the interdigital transducer (IDT) used for excitation. It is to be noted that the acoustic wavelength equals twice the electrode pitch. The use of multilayered substrates instead of traditional bulk piezoelectric substrates has led to significant improvements in $k_{eff}^2$, Q, and scalability to frequencies beyond 1 GHz for SAW devices. State-of-the-art SAW resonators employ thin films of either lithium niobate (LiNbO₃) or lithium tantalate (LiTaOs) bonded to materials with high acoustic velocities (Si, SiC, Quartz) or Bragg reflector stacks. Enabled by these novel substrates, SAW resonators with resonance frequencies beyond 3 GHz with high quality factors and $k_{eff}^2$ > 20% have been achieved. Filter prototypes that cover large fractions or full width of the n77, n78 and n79 bands with low insertion loss (IL) based on LiNbOs-SiC and LiNbOs-SiO₂-Si heterostructure SAW resonators have been demonstrated recently.

Resonators exploiting acoustic waves in suspended films of LiNbOs or AlScN, such as symmetric and antisymmetric Lamb waves, shear horizontal (SH) waves, or cross-sectional Lamé modes (CLM), have garnered interest as alternatives to classical BAW and SAW resonator architectures. Since the deformation of the piezoelectric layer is not constrained in this configuration, plate waves generally demonstrate higher $k_{eff}^2$ than what is possible with SAW modes, which facilitates synthesis of wide bandwidth filters. The suspended structure also reduces leakage of acoustic energy, resulting in low substrate losses even at high frequencies. So far, the most promising solutions in that category for wide bandwidth filters for the 5G mid-band spectrum and beyond have been based on suspended thin films of LiNbOs operating with the first-order antisymmetric Lamb mode (A1, i.e. XBAR) and first-order shear horizontal mode (SH1) due to high acoustic velocity $v_p$ ($f_s = v_p/\lambda$) and $k_{eff}^2$ of these modes. However, the achievable $f_s$ in these types of devices is strongly dependent on film thickness, and the tunability by varying IDT layout is limited.

Propagating modes that are excitable in suspended LiNbOs films, such as the fundamental shear horizontal (SH0) and symmetric (S0) modes provide a greater degree of flexibility. In this context, a propagating mode refers to an acoustic wave in a suspended film that travels along a direction parallel to the surface of the suspended film. The SH0 mode is a shear horizontal mode, where the particle motion is horizontal and perpendicular to the direction of wave propagation (i.e., within the plane of the film). The S0 mode is a symmetric Lamb wave mode, where the displacement is symmetric with respect to the midplane of the film. The particle motion involves both longitudinal (in the direction of propagation) and vertical (normal to the film surface) displacements. Like SAWs, SH0 and S0 modes can be excited with IDTs and thus benefit from lithographically defined $f_s$. Furthermore, $v_p$ of these modes is only weakly dependent on the film thickness $t$, allowing for a wide range of $f_s$ on a single substrate. Several implementations of SH0 and S0 resonators with sufficiently high $k_{eff}^2$ values that would theoretically enable for the large FBWs required for the n77-79 bands have been demonstrated but at frequencies below 3 GHz. Scaling of SH0 and S0 resonators to the 5G has been difficult due to a drastic decrease in $k_{eff}^2$ when the ratio of the thickness of the piezoelectric film $t$ to acoustic wavelength $\lambda$ exceeds 0.1. A possible approach to overcome this limitation and allow for small $\lambda$ concurrent with high $k_{eff}^2$ is to reduce the thickness of the suspended LiNbOs film and IDT electrodes. However, this approach presents practical challenges, including potential mechanical stability issues and increased electrical resistance.

US9,929,717B2 discloses an elastic wave device including a piezoelectric substrate and an interdigital transducer electrode disposed in a piezoelectric vibrating portion of the piezoelectric substrate to pass through the piezoelectric substrate. The resonator according to US9,929,717B2 appears very difficult to fabricate because the electrodes pass through the piezoelectric substrate. Furthermore, with through holes passing through the entire thickness of the piezoelectric film, the structure is be held together by only the adhesion of the filled-in metal. Considering that there are often residual stresses in piezoelectric films, it is possible that gaps could form between the metal electrodes and the piezoelectric film. Moreover, the resonator operates only in the SH0 mode.

## SUMMARY OF THE INVENTION

It is an object of the present invention to overcome at least some of the shortcomings identified above relating to acoustic wave resonators. More specifically, the present invention proposes an improved acoustic wave resonator comprising a suspended piezoelectric resonator structure, such as an LiNbOs resonator, which overcomes the frequency limitations of the SH0 and S0 modes. The present invention equally proposes a fabrication method thereof.

According to a first aspect of the invention, there is provided an acoustic wave resonator as recited in claim 1.

One of the novelties of the proposed resonator is the integration of buried IDT (B-IDT) electrodes instead of conventional (i.e., surface) IDT electrodes (S-IDT) deposited on top of the suspended piezoelectric film, which may be an LiNbOs film. With a suspended structure, the use of B-IDT electrodes allows for high $k_{eff}^2$

SH0 and S0 resonances at small $\lambda$ without requiring a simultaneous reduction of the piezoelectric film and electrode thickness. Furthermore, the proposed resonator overcomes the problems identified above in connection with the brief description of US9,929,717B2.

The proposed resonator exhibits high $k_{eff}^2$ over the whole frequency range achieving 32.1% at 3.5 GHz (SH0, 700 MHz resonance to anti-resonance) and 15.1% at 5.8 GHz (S0, 490 MHz resonance to anti-resonance) with Q on the order of 100. Enabled by the performance enhancement achieved with the B-IDT architecture, purely acoustic filters for the full n77 and n79 bands using SH0/S0 resonators in a suspended configuration are achieved for the first time. The measured responses (with 50Ω port impedances) show centre frequencies of 3.81 GHz and 4.80 GHz, FBW of 24.8% and 13.2%, and minimum insertion loss of 0.8 and 1.5 dB, respectively. The reported results highlight the suitability of SH0 and S0 resonators for 5G filtering applications as an alternative to established XBAR-type suspended devices.

According to a second aspect of the invention, there is provided a method for fabricating an acoustic wave resonator as recited in claim 15.

Other aspects of the invention are recited in the dependent claims attached hereto.

## BRIEF DESCRIPTION OF THE DRAWINGS

Other features and advantages of the invention will become apparent from the following description of a non-limiting example embodiments, with reference to the appended drawings, in which:

- Figure 1 shows in a schematic perspective view an example one-port acoustic wave resonator comprising a suspended piezoelectric film with an array of buried IDT electrodes according to a first embodiment of the present invention;

- Figure 2 shows in a top view a portion of the acoustic wave resonator of Figure 1, and in a cross-sectional view the acoustic wave resonator of Figure 1;

- Figure 3 shows the orientation of the resonator on a wafer with respect to the crystalline X-axis of LiNbO$_3$;

- Figure 4 shows the corresponding stress distributions of the excited modes for the resonator orientation shown in Figure 3;

- Figure 5 shows the angle of the electric field vector with respect to the horizontal direction for B-IDT structures;

- Figure 6 shows the simulated evolution of $k_{eff}^2$ for the SH0 and S0 modes for different $t_b/t$ ratios for the B-IDT scenario;

- Figure 7 shows simulated acoustic phase velocities $v_p$ for the SH0 and S0 modes;

- Figure 8 shows measured admittance of two B-IDT resonators that are aligned with the crystalline X axis of LiNbOs for maximised electromechanical coupling with the SH0 mode;

- Figure 9 shows measured admittance of two B-IDT resonators with the same layout as in Figure 8 but rotated by 48° on the chip surface;

- Figure 10 shows in a top view a portion of an acoustic wave resonator, and in a cross-sectional view the acoustic wave resonator according to a second embodiment of the present invention;

- Figure 11 is an optical microscope image of a fabricated filter comprising a set of acoustic resonators;

- Figures 12a to 12f illustrate different electrode designs in cross-sectional views;

- Figures 13a to 13c illustrate different configurations for temperature compensation; and

- Figures 14a to 14j illustrate a schematic overview of processing steps of the process flow used for B-IDT resonator fabrication.

## DETAILED DESCRIPTION OF EMBODIMENTS OF THE INVENTION

Some embodiments of the present invention are explained in the following in more detail. The term "comprise" is used herein as an open-ended term. This means that an object encompasses all the elements listed, but may also include additional, unnamed elements. Thus, the word "comprise" is interpreted by the broader meaning "include", "contain" or "comprehend". Identical or corresponding functional and structural elements which appear in the different drawings are assigned the same reference numerals. Different drawings are not necessarily drawn to scale. It is to be noted that the use of words "first", "second" and "third", etc. may not imply any kind of particular order or hierarchy unless this is explicitly or implicitly made clear in the context.

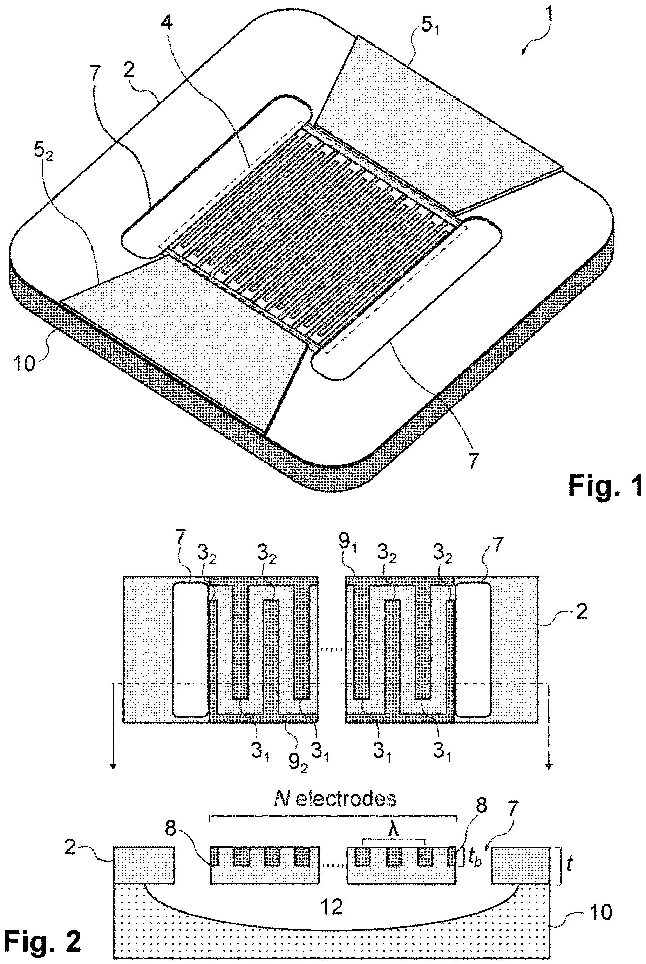

The overall structure of the proposed acoustic wave resonator 1, which is a suspended B-IDT resonator, is shown in Figures 1 and 2. The proposed resonator 1 could be integrated for example into a wireless communication device, such as a mobile phone. The resonator body consists of a suspended piezoelectric film or substrate 2, which in this example is a film of $LiNbO_3$ with an array of electrode fingers or electrodes 3 with alternating polarity collectively forming an IDT 4. For the substrate 2, a lithium tantalate (LiTaOs) film could additionally or instead be used. A set of first electrodes 3, are thus connected to a power source (not shown), such as a positive voltage source, while a set of second electrodes $3_2$ are in this example grounded. An IDT can be understood as a device that consists of two interlocking comb-shaped arrays of electrodes (in the fashion of a zipper). These electrodes are in the present invention buried or partially buried in the piezoelectric substrate to form a periodic structure. At its ends, the IDT in this example is connected to electrically conductive regions having a thick metal layer forming contact pads $5_1$, $5_2$. More specifically, the IDT 4 is connected through a first bus bar 9, (which is an electrically conductive region) to a first contact pad $5_1$, which in this example is connected to a power source (not shown in the figures), such as a positive voltage source, and through a second bus bar $9_2$ (which is an electrically conductive region) to a second contact pad $5_2$, which in this example is grounded. In this arrangement, the electrodes longitudinally extend between the first and second contact pads. In this embodiment, the lateral boundaries of the IDT 4 are defined with a respective opening 7 in the $LiNbO_3$ film. In other words, the lateral boundaries of the IDT 4 are formed by a first release hole 7 and a second release hole 7. In this manner, the free edge parallel to the longitudinal axis of the electrodes 3 acts as an edge reflector 8 confining the acoustic energy in the suspended film. The edge of the lateral release holes 7 is placed in the centre of the laterally last B-IDT electrode at both sides as is shown in Figure 2. In other words, the leftmost and rightmost electrodes have a width, measured orthogonally to the longitudinal axis of the electrodes, which is substantially half of the width compared with the other electrodes. The defining characteristic of a B-IDT resonator is that the electrodes forming the IDT are embedded in the piezoelectric film rather than being deposited on top of it. In this example, aluminium was chosen as an electrode material for its low density, high conductivity, and ease-of-use for microfabrication. However, other electrically conductive materials, such as other metals, may be used to make the electrodes. In particular, the electrodes may be made or primarily made of a metal selected from a group consisting of Al, Cu, Cr, Ru, Ti, Be, W, Au, Pt, Ta, Mo, and Ni.

As is further shown in Figures 1 and 2, the $LiNbO_3$ film 2 is placed on top of a base substrate 10. In this example, the LiNbOs film is directly placed on top of the base substrate. In other words, the $LiNbO_3$ film is in direct contact with the base substrate, but this does not have to be the case. As is further shown in Figure 2, there is a cavity 12 between the $LiNbO_3$ film 2 and the base substrate 10 in the centre region of the resonator 1 to suspend or hang the LiNbOs film. The $LiNbO_3$ film 2 is thus directly or indirectly supported by the base substrate 10 such that the LiNbOs film 2 has a suspended portion above the base substrate 10.

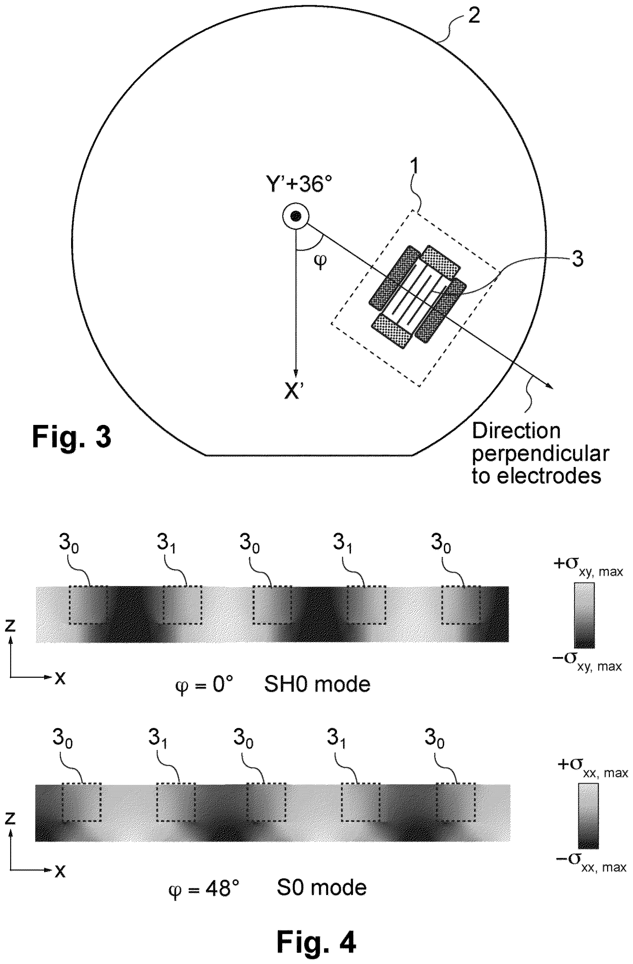

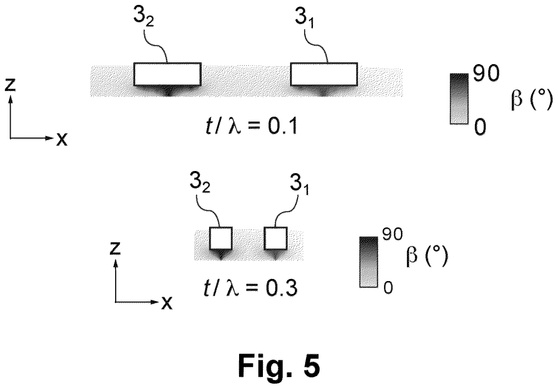

Figure 3 shows the orientation $\varphi$ of the resonator 1 on the wafer with respect to the crystalline X-axis of LiNbOs (denoted X' in Figure 3), and Figure 4 shows the corresponding stress distributions of the excited modes. In this example, as illustrated in Figure 3, a film of YX36°-cut $LiNbO_3$ is chosen for both modes as both modes can be excited selectively by varying device orientation with respect to the crystallographic axis. If the exciting electric field generated by the power source (which may be configured to catch and/or process electromagnetic radiation) and fed to the resonator through the contact pads is aligned with the crystalline X axis, a strong SH0 wave is excited due to a large $e_{16}$ coefficient. At a 48° offset from the crystalline X axis, $e_{11}$ is non-zero which enables excitation of the S0 mode. The excitation of both modes relies on a horizontal electric field (parallel to the film surface) between two adjacent electrodes. Thus, designing the IDT electrodes 3 so that the resulting field distribution is as horizontal as possible is important for maximising $k_{eff}^2$ of these acoustic modes. Figure 5 shows the angle of the electric field vector with respect to the horizontal direction for B-IDT structures. For conventional S-IDT, the electric field would be substantially perfectly horizontal only near the top surface of the film. Under the electrodes, the electric field is primarily vertical and does not contribute to the generation of the intended SH0 and S0 waves. In addition, vertical electric field components may excite undesired spurious modes due to the non-zero $e_{3j}$ components in the piezoelectric tensor of $LiNbO_3$. These two effects are exacerbated when the ratio of piezoelectric film thickness $t$ to $\lambda$ becomes large which is inevitably the case when upscaling $f_s$ unless $t$ is reduced simultaneously. With B-IDT electrodes on the other hand, the electric field is substantially purely horizontal and uniform between the electrodes and areas with vertical components are minimised. If the buried depth $t_b$ or more precisely the depth of the trenches where the buried electrodes are formed is a significant fraction of $t$, such an optimal electric field distribution can be ensured even for high $t/\lambda$. Advantageously, $t$ is equal to or smaller than $\lambda$.

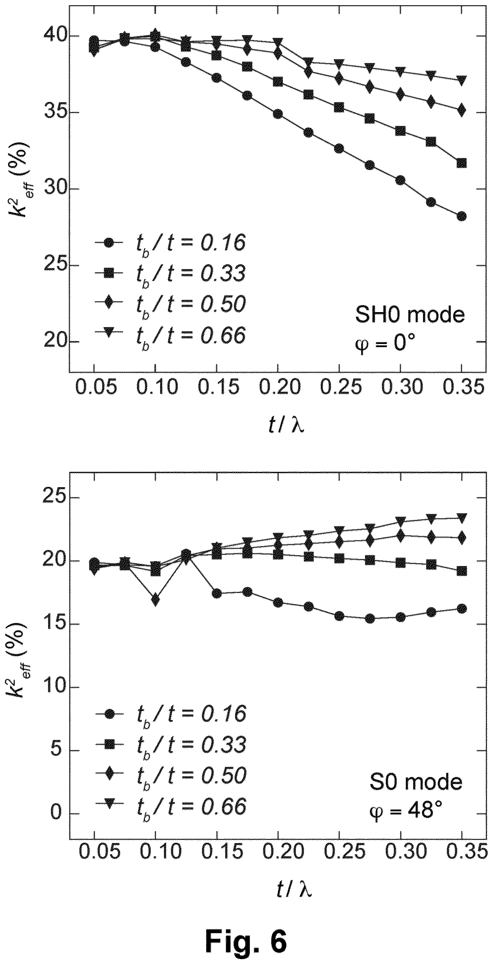

Figure 6 shows the simulated evolution of $k_{eff}^2$ of the SH0 and S0 modes with $t/\lambda$ on the horizontal axis for different $t_b/t$ ratios for the B-IDT scenario. The efficacy of the conventional S-IDT structure for high-frequency operation would be compromised due to a significant decline in $k_{eff}^2$ with small $\lambda$. Especially the S0 mode cannot be excited efficiently at $t/\lambda > 0.3$ due to the deteriorating effect of the electrodes on the surface and the sub-optimal electric field distribution. In contrast, the dispersion of $k_{eff}^2$ is reduced with a B-IDT structure, and high $k_{eff}^2$ can be attained for both modes even at $t/\lambda > 0.3$. Simulated acoustic phase velocities $v_p$

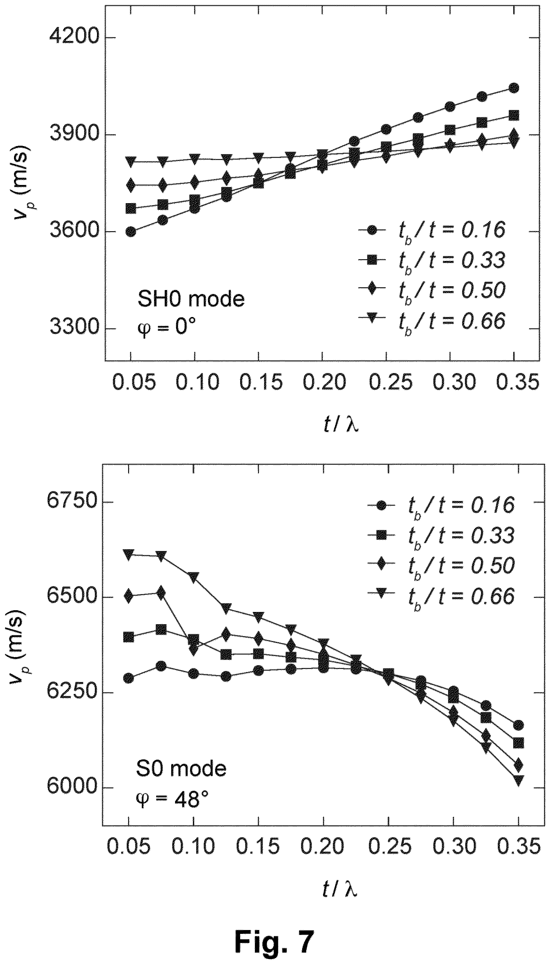

for both SH0 and S0 modes are presented in Figure 7. Forming the electrodes by replacing parts of the piezoelectric film with metal rather than depositing on the surface leads to mode shapes that are favourable for high $k_{eff}^2$ and $v_p$ even for small $\lambda$. With enhanced $k_{eff}^2$ and $v_p$, particularly for high $t/\lambda$, the B-IDT structure demonstrates superior suitability for high-frequency operation.

Moreover, the reduction in dispersion of $k_{eff}^2$ and $v_p$ facilitates the fabrication of devices with lithographically tuned resonance frequencies spanning a broad spectrum, while maintaining consistent performance metrics.

Creating a structure with embedded metal features in the $LiNbO_3$ film 2 presents several fabrication challenges including the patterning of narrow yet sufficiently deep trenches into the $LiNbO_3$ film followed by filling with aluminium (or with another suitable electrically conductive material) without leaving gaps between the electrode material and LiNbOs sidewalls. A fabrication process flow for B-IDT resonators and filters was developed and is described later in detail in the present description. Fabrication was performed on chip level, but the process can easily be scaled to wafer level without any modifications. The outline of the process is inspired by the widely used Damascene process for interconnects and previous demonstrations of SAW devices with buried electrodes. The most notable difference in the developed process flow is the absence of chemical mechanical polishing (CMP) that is typically used for planarization of the sample after metallisation. However, in the context of the specific type of structure that is fabricated in this work, the chip and feature-scale non-uniformities that are common with CMP may render a large portion of devices on a sample unusable. Instead, an innovative polishing process was developed that features excellent uniformity, material selectivity and the possibility to be applied only locally. The developed polishing process does not damage the LiNbOs surface between the electrodes and can be controlled to adjust the height of the electrodes, optionally protruding from the $LiNbO_3$.

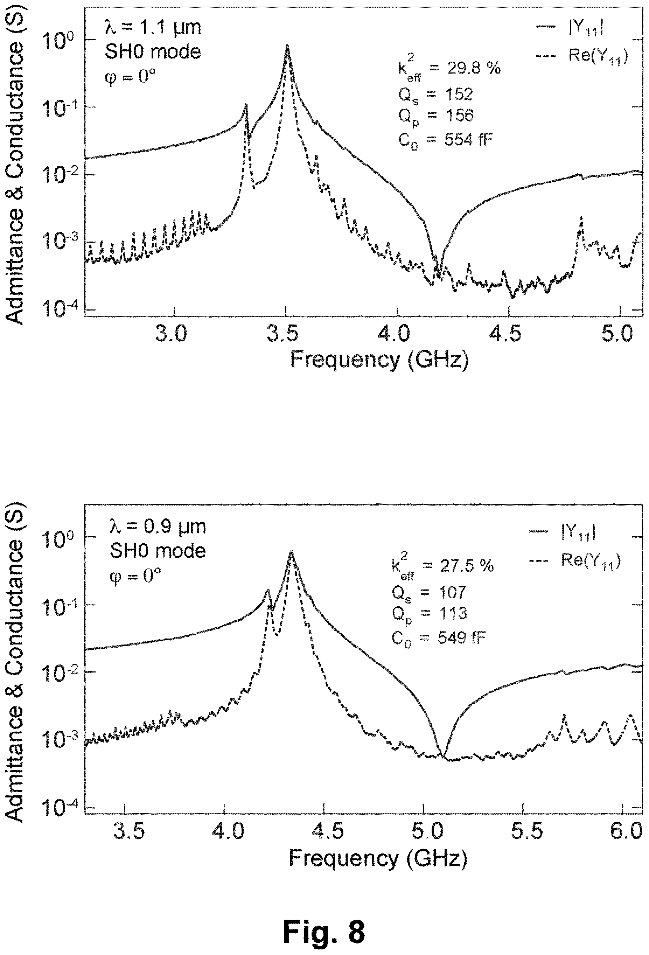

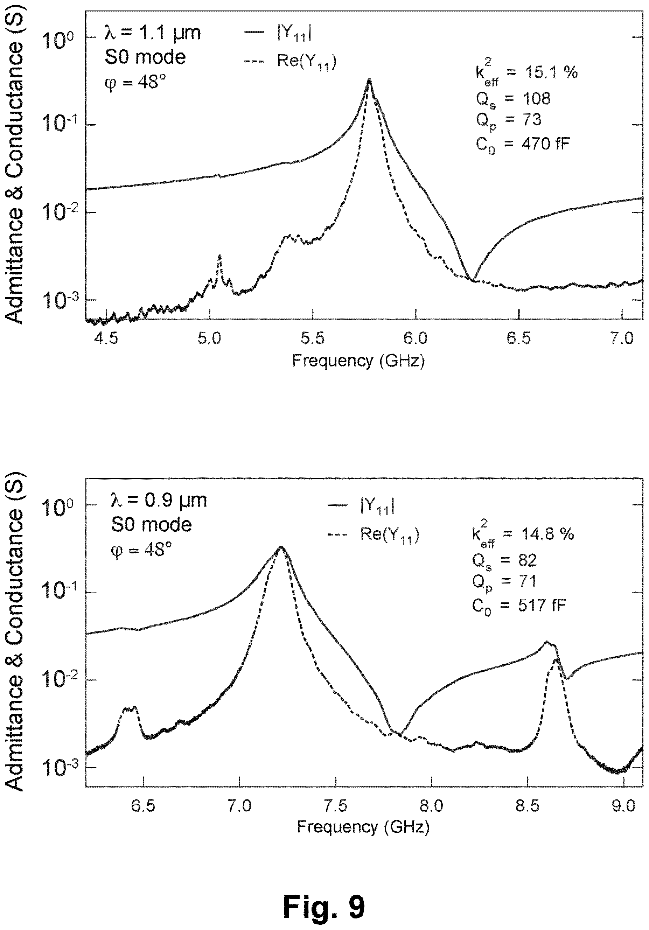

Figures 8 and 9 show measured admittance of four fabricated B-IDT resonators 1. In those examples, the thickness of the LiNbOs film $t$ is 300 nm and the buried depth $t_b$ is approximately 200 nm (0.66 · $t$). Figure 8 shows the measured admittance of two resonators 1 that are aligned with the crystalline X axis of LiNbOs for maximised electromechanical coupling with the SH0 mode. A strong SH0 resonance with large $k_{eff}^2$ close to 30% and resonance quality factors $Q_s$ over 100 can be observed. The wavelengths of the shown devices yield resonance frequencies $f_s$ within the 3-5 GHz range of the n77-n79 bands. Owing to high $k_{eff}^2$, around 700 MHz of separation between the resonance and anti-resonance frequencies (frequencies of maximum and minimum admittance, respectively) with an impedance ratio of over three decades (ratio of admittance at the resonance frequency to admittance at the anti-resonance frequency) can be reached which is highly promising for large-bandwidth filters. Figure 9 shows measured admittance of two resonators 1 with the same layout as in Figure 8 but rotated by 48° on the chip surface. The main resonance mode corresponds to an S0 mode with lower $k_{eff}^2$ but higher resonance frequency compared to the SH0 resonators due to the faster acoustic phase velocity of the S0 wave. It is to be noted that with the specific choice of on-chip device orientations, the SH0 and S0 modes never appear simultaneously in the same resonator.

For both SH0 and S0 resonators, the conductance shows small ripples at periodic frequency intervals below $f_s$. For the SH0 resonators in Figure 8, a prominent spurious mode appears close to $f_s$. Similar modes, albeit less pronounced, are visible in Figure 9 as bumps in the conductance at approximately 5.4 GHz for $\lambda = 1.1\ \mu$m and adjacent to the resonance peak at 7.2 GHz for $\lambda = 0.9\ \mu$m. The appearance of these modes is linked to misalignment of the edge reflector 8 with respect to the last IDT fingers which represents a perturbation of the B-IDT grating periodicity. The misalignment of the release holes 7 in the fabricated resonators is typically on the order of 100 nm or smaller and can vary across a chip. With $\lambda$ on the order of a micron, this is sufficient to significantly alter the reflection characteristics of the acoustic wave at the etched boundaries. Importantly, this does not represent a major downside of these devices, since standard lithographic tools in well-controlled environments can now reach alignment accuracy down to 10 nm.

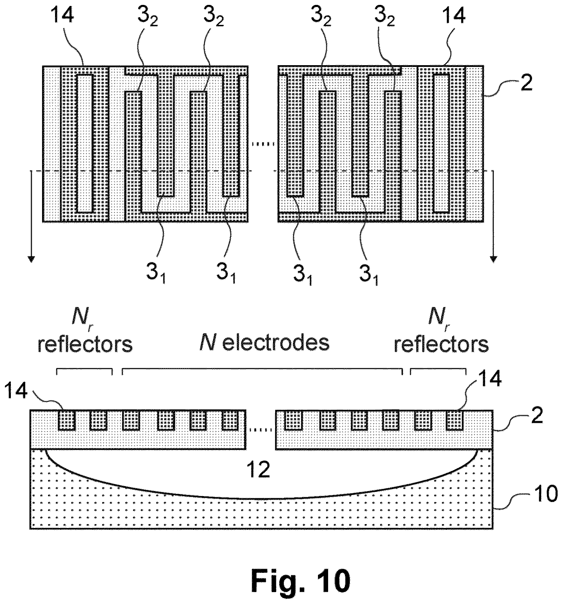

The second embodiment of the present invention is explained next with reference to Figure 10. To suppress the appearance of spurious modes in the vicinity of the main resonance due to misalignment of the release holes 7, resonator designs with grating reflectors 14 are implemented. As is shown in Figure 10, a grating reflector 14 is provided on each lateral side of the IDT 4. In this example, the respective grating reflector 14 comprises a plurality of short-circuited B-IDT electrodes (which could instead be open-circuited) placed at the respective side of the active transducer area instead of the release hole 7. The reflector and transducer elements are defined in the same lithographic mask, thus the issues pertaining to any misalignment of the reflection boundary are avoided. The procedure employed to release the resonators with grating reflectors is described later in more detail. The resonance frequencies do not change significantly compared to resonators with edge reflectors 8. The most notable advantage over resonators with edge reflectors is the absence of strong spurious modes to the left of the main resonance peak.

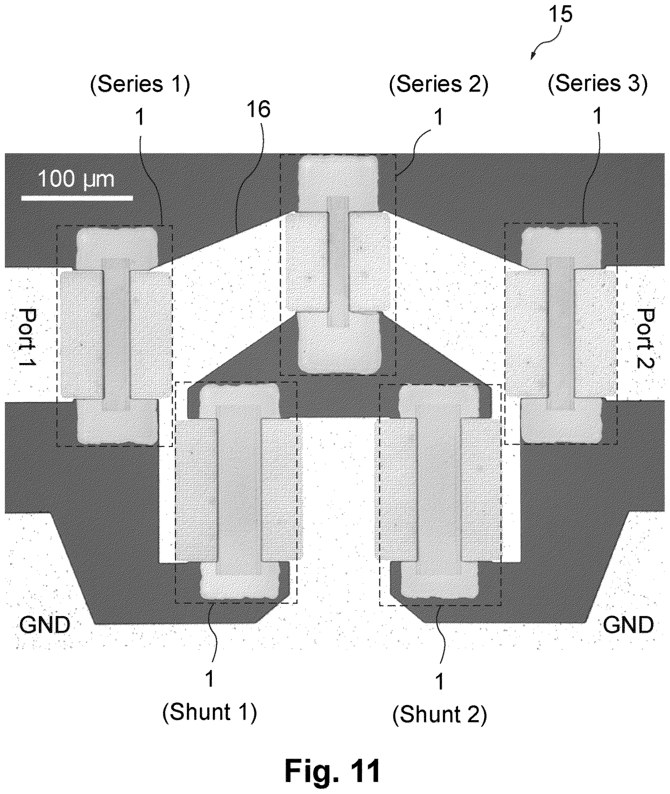

To demonstrate the suitability of B-IDT resonators as building blocks in wideband filters for the 5G midband spectrum, filters for the n77 and n79 bands with a simple 2.5-stage ladder topology are synthesised and fabricated. For the n77 band filter (Filter 1), B-IDT resonators operating in the SH0 mode are chosen due to their superior $k_{eff}^2$ which is sufficiently large to reach an FBW of 24% to cover the entire width of the band. For the n79 band located in the 4-5 GHz range, S0 mode B-IDT resonators are well suited owing to the high $v_p$ of the S0 mode (Filter 2). An optical microscope image of the fabricated device 15, which forms a signal filter, is shown in Figure 11. As can be seen, the filter 15 in this example comprises five acoustic resonators 1 connected by electrical conductors 16, such as metal connections. Furthermore, the filter 15 in this case has a two-port design, comprising a first port (Port 1), and a second port (Port 2). In this example implementation, resonator designs with grating reflectors 14 are chosen since the avoidance of spurious modes is important for smooth filter pass bands. To ensure high out-of-band rejection, low insertion loss and sufficient matching to 50 $\Omega$ in the pass band, the capacitances of individual resonators are tuned by varying the number of electrode pairs in the transducer and electrode length. It is to be noted that the filter design is not limited to filters with six resonators. Furthermore, the filter design is also not limited to the specific topology shown in Figure 11. The number of acoustic resonators per filter is typically in the range of 3 to 12, or more specifically in the range of 5 to 9.

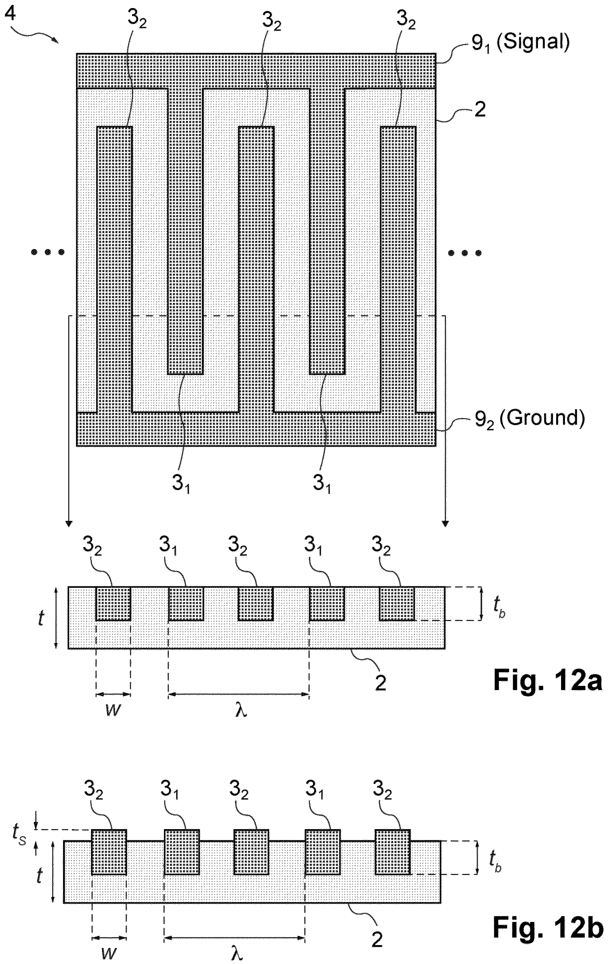

Figures 12a to 12f illustrate in cross-sectional views different electrode designs, and therefore also different transducer designs. The thickness of the LiNbOs film $t$ may be in the range of 50 nm to 500 nm, or more specifically between 100 and 300 nm. Figure 12a illustrates the design of Figure 2, where the electrodes 3 have a rectangular, such as a square-shaped, cross-section orthogonally to the longitudinal axis of the electrodes. Furthermore, in this design, the electrodes are flush or substantially flush with the top or upper surface of the LiNbO$_3$ film 2. In other words, in this case, the electrodes 3 do not protrude from the upper surface of the LiNbO$_3$ film 2. The design of Figure 12b differs from the design of Figure 12a in that in this design, the electrodes 3 protrude from the upper surface of the LiNbOs film 2. The protrusion distance is denoted by $t_s$, and the greatest width of the electrode trench is denoted by $w$. Thus, as can be seen in Figure 12b, the electrode cross section orthogonally to the longitudinal axis of the electrodes has an elongated shape, such that the direction of extension is upwards away from the upper surface of the LiNbO$_3$ film 2.

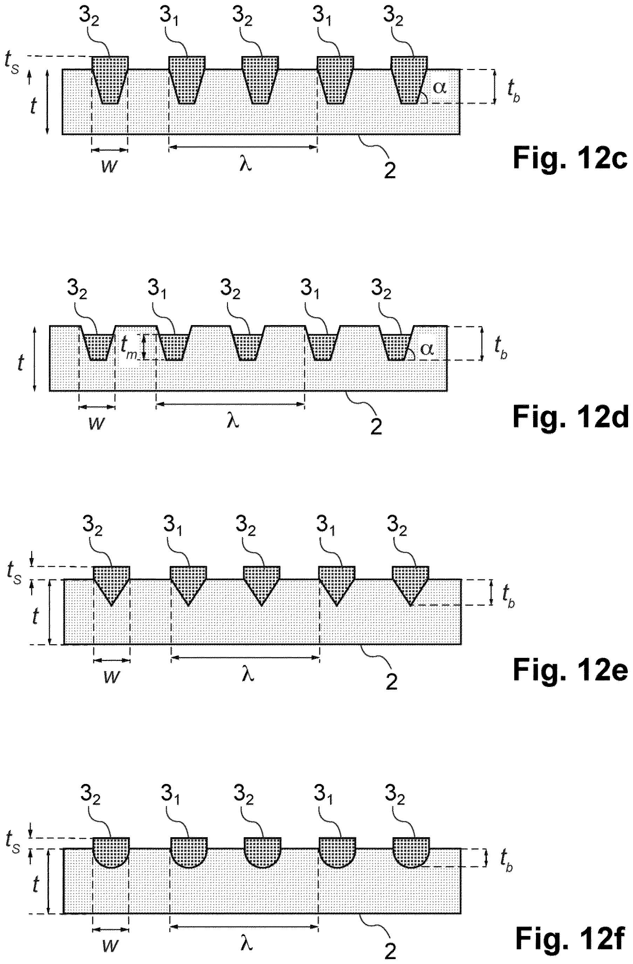

The design of Figure 12c differs from the design of Figure 12b in that the side surfaces of the electrodes are angled in the LiNbOs film 2. In other words, the electrode cross section orthogonally to the longitudinal axis of the electrodes is not rectangular, but instead the cross section has a tapered or partially tapered shape. In other words, one or both of the electrode side surfaces are sloped towards the centre of the respective electrode so that if both side surfaces are sloped, then they are sloped towards each other. The angle between the electrode side surface in the buried portion and a plane parallel to the upper surface of the $LiNbO_3$ film 2 is denoted by $\alpha$. This electrode side surface angle may be in the range of 45° and 90°, and more specifically between 45° and 80°, or more specifically between 60° and 80°.

The design of Figure 12d differs from the design of Figure 12c in that that the electrodes 3 do not protrude from the top surface of the LiNbOs film 2. In fact, in this example, the electrodes are buried in the $LiNbO_3$ film 2 such that they do not even reach the top surface of the LiNbOs film 2. The design of Figure 12e differs from the design of Figure 12c in that that the buried portion of the electrodes have a triangular cross section orthogonally to the longitudinal axis of the electrodes. In this case, the electrode side surfaces are also angled more than in the design of Figure 12c. The design of Figure 12f differs from the design of Figure 12e in that that the buried portion of the electrodes has a rounded, such as a semi-circular, cross section orthogonally to the longitudinal axis of the electrodes. It is to be noted that any combination of the above designs is equally possible in addition to other suitable design variants.

According to the above designs, the electrodes are formed or partially formed in trenches with a given maximum trench width $w$, and where the maximum trench width w to acoustic wavelength ratio $\lambda$ is in the range of 0.1 to 0.8. Resonator performance is best for a ratio of approximately 0.5 but good electromechanical coupling can be achieved with higher values, especially when the sidewalls are sloped. In addition, if this ratio is greater than 0.5, this can enable excitation of the 3rd harmonic of the acoustic wave at three times the frequency. Thus, according to one example, the ratio $w/\lambda$ is greater than 0.5, but smaller than 0.8. Furthermore, the electrodes 3 only partially pass through the LiNbOs film 2. Specifically, the electrodes are designed so that the ratio $t_b/t$ is advantageously greater than 0.3, but smaller than 1, 0.8, or 0.7.

The reported architecture for acoustic resonators 1 based on suspended piezoelectric films, such as films of LiNbOs, in combination with buried IDT electrodes 3 effectively enables scalability of SH0 and S0 resonances to the 5G mid-band spectrum. The integration of B-IDT electrodes 3 provides a solution to overcome the $\lambda$ versus $k_{eff}^2$ tradeoff that limits the potential of conventional S-IDT SH0 and S0 resonators for wideband filtering applications at high frequencies. The demonstrated resonator platform combines the advantages of lithographic modulation of $f_s$, device orientation dependent mode selectivity, and high $k_{eff}^2$ operation over an extensive frequency range. With these attributes, the integration of multiple filters for wide 5G bands with various centre frequencies on the same substrate can be envisioned as highlighted by the presented filters for the n77 and n79 bands. In addition, it is feasible to implement filters composed of both SH0 and S0 resonators as building blocks for FBWs in the 13-24% range, such as for the n78 band. Further improvements to the performance of the demonstrated n77 and n79 band filters, such as passband flatness or out-of-band rejection, could likely be achieved with more sophisticated filter designs.

At the resonator level, optimisation of the fabrication processes for $LiNbO_3$ patterning and metal deposition selection and potentially an alternative electrode metal could be explored to minimise acoustic losses. Moreover, considering future deployment of the sixth-generation (6G) wireless communication standard, further increases of $f_s$ to 10 GHz or more without compromising $k_{eff}^2$ could be envisioned for SH0 and S0 resonators by adopting thinner LiNbOs film and smaller acoustic wavelengths in combination with B-IDT electrodes. Lastly, the B-IDT concept and presented fabrication method thereof could be applied to a variety of resonator types that rely on IDTs for transduction such as XBAR or SAW-type resonators.

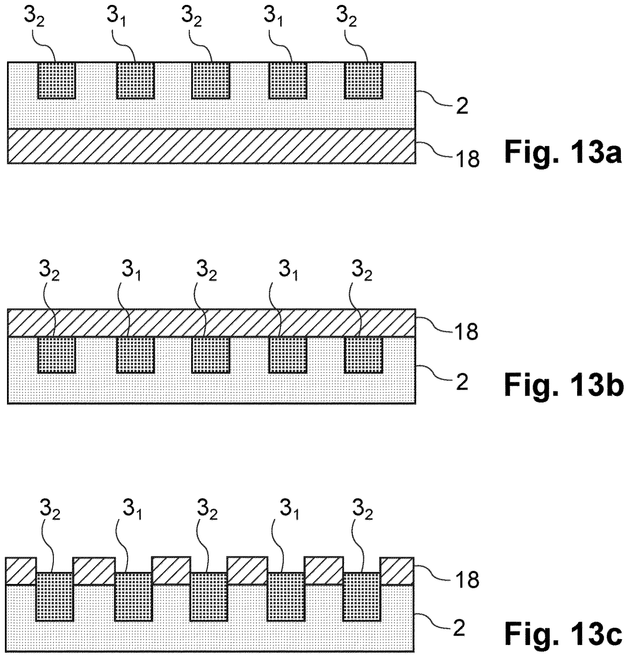

Temperature compensation could be addressed by integrating a layer of silicon dioxide ($SiO_2$) or a layer of another suitable material, such as silicon oxynitride ($SiO_xN_y$), on the upper (top) and/or lower (bottom) surfaces of the piezoelectric film 2. Figure 13a shows a configuration, where the $SiO_2$ layer 18 acting as a temperature compensation layer is placed at the lower surface of the piezoelectric film 2, to be in this case in direct contact with the piezoelectric film 2. In this scenario, the $SiO_2$ layer 18 would be sandwiched between the piezoelectric film 2 and the base substrate 10. Figure 13b shows a configuration where the $SiO_2$ layer 18 is placed at the upper surface of the piezoelectric film 2, to be in this case in direct contact with the piezoelectric film 2. In the configuration of Figure 13c, the $SiO_2$ film 18 is placed at the upper surface of the piezoelectric film 2 between the electrodes 3. Also in this configuration, the $SiO_2$ film is in direct contact with the piezoelectric film 2. Furthermore, in this example, the electrodes 3 protrude from the upper surface of the piezoelectric film 2.

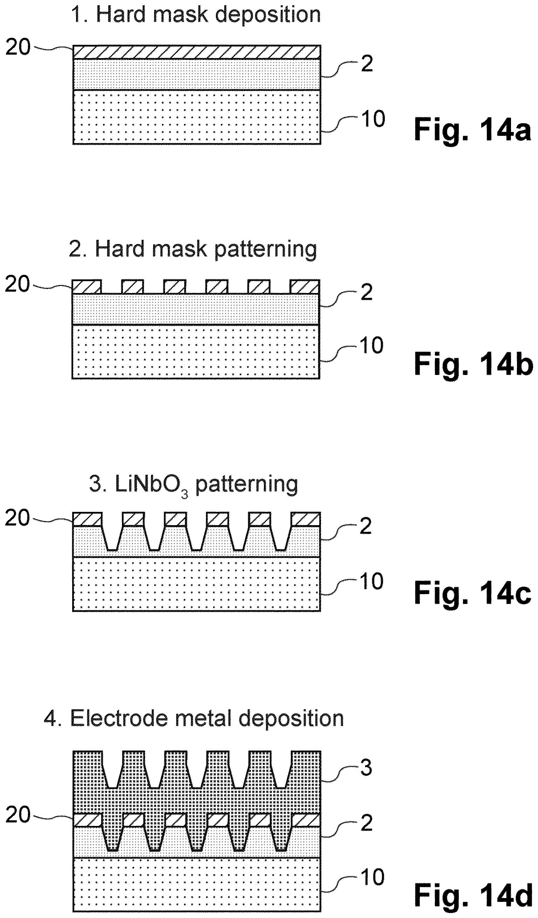

The fabrication process of the B-IDT resonator 1 is next illustrated in more detail with reference to Figures 14a to 14j. For device fabrication, substrates consisting of a for instance 300 nm thick, monocrystalline YX36°-cut LiNbOs thin film 2 bonded to a high-resistive silicon wafer 10 are used. The fabrication process flow can be subdivided into four different parts. First, the trench pattern for the buried metal layer is etched into the $LiNbO_3$ film 2. Second, metal material, such as aluminium, is deposited to fill the patterned trenches. Third, the surface is planarized with a polishing process. Finally, the release holes are patterned (if release holes are used), and the device is released by removing the silicon underneath.

To start, in step 1 as shown in Figure 14a, a hard or protective mask or layer 20 for LiNbOs etching is deposited by e-beam evaporation on the upper surface of the LiNbOs film 2. The hard mask film in this example consists of a chromium layer. The thickness of this layer may be in the range of 50 nm to 300 nm. In this example, the thickness of the hard mask film 20 is approximately 150 nm. In step 2 as shown in Figure 14b, the hard mask film 20 is patterned using e-beam lithography and ion beam etching (IBE). Next in step 3 as shown in Figure 14c, the underlying LiNbOs film 2 is patterned, in this case by reactive ion etching (RIE) in an etcher using $CHF_3$/Ar chemistry, for instance. The etch duration is controlled to achieve a given trench depth $t_b$. The trench depth $t_b$ is a fraction of the thickness of the $LiNbO_3$ film $t$ and may be greater than $0.3 \cdot t$ but smaller than $t$ and more specifically in the range of $0.5 \cdot t$ to $0.7 \cdot t$. In the present case, the thickness of the LiNbOs $t$ is 300 nm and the trench depth is approximately $0.66 \cdot t$ or 200 nm. The layout of the etched features is designed to avoid aspect-ratio dependent non-uniformity of the etch rate and ensure that the trench depth is the same or substantially the same for all features. Specifically, in the present example, all trenches for the electrodes are designed to have a width of 220 nm ($w$ = 220 nm) independent of $\lambda$. The maximum trench width $w$ could be designed to be in the range of 50 to 500 nm, or more specifically in the range of 100 nm to 300 nm. Furthermore, any larger features, such as the bus bar and pad regions, are replaced by dense gratings of trenches with the same width as the trenches for the electrodes. In the present example, the profile of the etched structures features a flat bottom and a sloped sidewall (for example $\alpha$ being in the range of 60° and 80°, such as approximately 70°). The selectivity of this etch process with the Cr hard mask is 3:1 in the present example. This means that three thickness units of $LiNbO_3$ is removed, while only one thickness unit of chromium is removed. Thus, around 90 nm of chromium remains after LiNbOs patterning which remains on the sample as it serves as a protective etch stop layer at a later stage of the fabrication process.

In step 4 as shown in Figure 14d, the etched trenches are metallised. In other words, the trenches are filled with electrode metal material 3. More specifically, the etched trenches are filled by evaporating an adhesion layer, which in this case is a chromium layer, with a thickness for instance of 10 nm, followed by a second layer of another metal material, which in this case is a layer of 600 nm of aluminium. The sloped trench profile makes it possible to fill in the trenches with evaporation with good coverage of the sidewalls and without any voids in the metal. Due to the directionality of evaporation, the topography of the features in the LiNbOs film 2 remains in the deposited aluminium film.

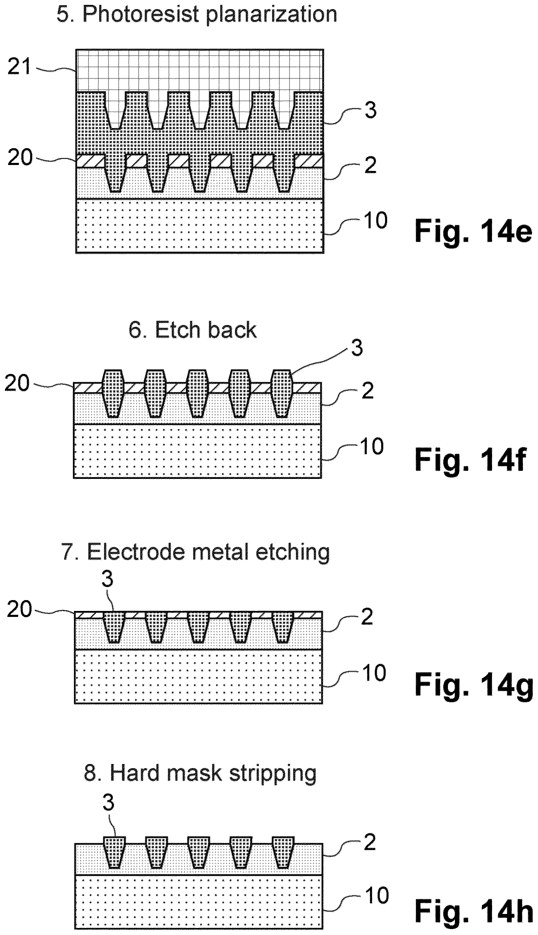

At this point, the thick aluminium layer 3 covers the entirety of the surface. The process next involves local planarization with a thick photoresist and dry etching. The aim of the following three steps is to remove the excess aluminium that is not filling a trench. The developed area-selective planarization process consists of planarizing in step 5 as shown in Figure 14e the surface with a thick layer (first layer) of photoresist (PR) 21 followed by etch-back in step 6 as shown in Figure 14f. After aluminium deposition, the surface is planarized by spin-coating in this example a 700 nm layer of negative tone photoresist. The coated PR layer is subjected to a blanket exposure followed by hardening phase during which a post-exposure bake is carried out to crosslink (harden) the entire film. Next, a second layer of the same PR is spin-coated on top of the first layer in the pad regions and patterned using a maskless aligner to selectively increase the total PR thickness adjacent to the transducer electrodes (i.e., in the pad regions). With this approach, the thick aluminium layer is protected from the following etch-back processes in these areas and thereby forms monolithic contact pads for the resonator or interconnects for the filters. The etch-back in step 6 starts with IBE until the chromium layer 20 covering the LiNbOs layer 2 between the electrodes 3 is reached. The resulting surface topography is not necessarily flat and is dependent on the removal rates with IBE of the involved materials. Interestingly, the PR 21 used has a higher resistance to ion bombardment than aluminium, which essentially leads to an inversion of the initial topography and thus excess aluminium on top of the filled trenches. These aluminium bumps are then flattened in step 7 as shown in Figure 14g using RIE with a recipe that features a high selectivity to chromium. The chromium layer protects the LiNbOs surface between the electrodes throughout all these etching processes. Finally, the remaining chromium is removed in step 8 as shown in Figure 14h with wet chemistry (wet etching) that does not attack the buried aluminium electrodes. Residual PR 21 in the pad regions is stripped using $O_2$ plasma.

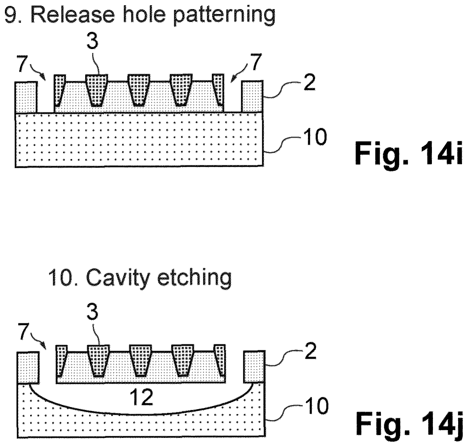

The following steps involve release hole patterning in step 9 as shown in Figure 14i, and device release in step 10 as shown in Figure 14j. The lateral release holes are patterned with E-Beam lithography, E-Beam resist, and IBE. After stripping of the resist mask, the devices are released in this case by removing the underlying Si using $XeF_2$ gas.

Devices with a design including grating reflectors instead of edge reflectors as acoustic wave reflector arrangements are released by etching a cavity into Si layer 10 from the back side of the substrate using deep reactive ion etching (DRIE) after the planarization step. The grating reflectors themselves are created in the above process of creating the buried electrodes.

As explained above, according to the present invention, the buried electrodes span through only a fraction of the entire thickness of the $LiNbO_3$ film. This does not necessarily lead to increased resonator performance compared to resonators, where the electrodes span the entire thickness. However, a transducer in which an electrode spans the entire thickness would be much harder to fabricate for the following two reasons: 1) For devices with small w, it might be extremely challenging to etch a hole through the entire thickness of the piezoelectric film. For example, with LiNbOs, it is difficult to etch holes that have aspect ratios ($t_b$/w) that are greater than 1 or possibly 1.5. 2) With a hole through the entire thickness, the structure would be "held together" by only the adhesion of the filled-in metal. Considering that there are often residual stresses in piezoelectric films, it is possible that gaps could form between metal and the piezoelectric film once the structure is released. Furthermore, tilted sidewalls ($\alpha < 90°$) is beneficial from a fabrication standpoint, because this feature facilitates the filling of the trenches with metal. In terms of resonator performance, the geometry with perfectly vertical sidewalls ($\alpha = 90°$) may be optimal, but good performance can be obtained also when $\alpha$ is less than 90°.

While the invention has been illustrated and described in detail in the drawings and foregoing description, such illustration and description are to be considered illustrative or exemplary and not restrictive, the invention being not limited to the disclosed embodiments. Other embodiments and variants are understood and can be achieved by those skilled in the art when carrying out the claimed invention, based on a study of the drawings, the disclosure and the appended claims. Further variants may be obtained by combining the teachings of any of the examples explained above. For example, instead of the buried electrodes extending from the upper surface of the piezoelectric film towards the lower surface, they could instead extend from the lower surface of the piezoelectric film towards the upper surface. A resonator design is also possible in which some of the electrodes extend from the upper surface towards the lower surface, and some other electrodes extend from the lower surface towards the upper surface. Furthermore, a resonator design would be possible in which one or more electrodes span through the entire thickness of the piezoelectric film, while other buried electrodes only partially span through the piezoelectric film.

In the claims, the word "comprising" does not exclude other elements or steps, and the indefinite article "a" or "an" does not exclude a plurality. The mere fact that different features are recited in mutually different dependent claims does not indicate that a combination of these features cannot be advantageously used. Any reference signs in the claims should not be construed as limiting the scope of the invention.

## Claims

1. An acoustic wave resonator (1) comprising:

    - a base substrate (10);
    - a piezoelectric substrate (2) directly or indirectly supported by the base substrate (10) such that the piezoelectric substrate (2) has a suspended portion above the base substrate (10);
    - a set of electrodes (3, $3_1$, $3_2$) buried in the suspended portion of the piezoelectric substrate (2) and forming an interdigital transducer (4), the electrodes (3, $3_1$, $3_2$) cross-sectionally extending in the piezoelectric substrate (2) between an upper surface and a lower surface of the piezoelectric substrate (2) in a thickness direction of the piezoelectric substrate (2); and
    - a set of electrical contact elements ($5_1$, $5_2$, $9_1$, $9_2$) connected to the interdigital transducer (4),

    wherein the electrodes (3, $3_1$, $3_2$) only partially span through the piezoelectric substrate (2) in the thickness direction of the piezoelectric substrate (2).

2. The acoustic wave resonator (1) according to claim 1, wherein the piezoelectric substrate (2) is made of LiNbO$_3$ and/or LiTaO$_3$.

3. The acoustic wave resonator (1) according to claim 1 or 2, wherein the electrodes (3, $3_1$, $3_2$) are made or primarily made of a metal selected from a group consisting of Al, Cu, Cr, Ru, Ti, Be, W, Au, Pt, Ta, Mo, and Ni.

4. The acoustic wave resonator (1) according to any one of the preceding claims, wherein the acoustic wave resonator (1) comprises a first acoustic wave reflector arrangement (7, 14) placed at a first lateral side of the interdigital transducer (4), and a second acoustic wave reflector arrangement (7, 14) placed at a second, different lateral side of the interdigital transducer (4).

5. The acoustic wave resonator (1) according to claim 4, wherein a respective acoustic wave reflector arrangement (7, 14) is a release hole (7) in the piezoelectric substrate (2) or an electrically conductive region disconnected from the interdigital transducer (4) forming a grating reflector (14).

6. The acoustic wave resonator (1) according to claim 5, wherein the grating reflector (14) comprises a set of short-circuited and/or open-circuited electrodes buried in the piezoelectric substrate (2).

7. The acoustic wave resonator (1) according to any one of the preceding claims, wherein the electrodes (3, $3_1$, $3_2$) have a non-rectangular cross-section orthogonally to a longitudinal axis of the electrodes (3, $3_1$, $3_2$).

8. The acoustic wave resonator (1) according to claim 7, wherein the cross section in a buried portion of the electrodes (3, $3_1$, $3_2$) has a rounded or triangular shape, and/or the electrodes (3, $3_1$, $3_2$) in the buried portion have at least one sloped side surface.

9. The acoustic wave resonator (1) according to claim 8, wherein the sloped side surface has an angle smaller than 90° but greater than 45° with respect to a plane parallel to the upper or lower surface of the piezoelectric substrate (2).

10. The acoustic wave resonator (1) according to any one of the preceding claims, wherein the acoustic wave resonator (1) further comprises a temperature compensation layer (18) placed on the upper or lower surface of the of the piezoelectric substrate (2), wherein the temperature compensation layer (18) is optionally a silicon oxide layer.

11. The acoustic wave resonator (1) according to any one of the preceding claims, wherein the electrodes $(3, 3_1, 3_2)$ are formed or partially formed in trenches with a given maximum trench width, and wherein the maximum trench width to acoustic wavelength ratio is in the range of 0.1 to 0.8.

12. The acoustic wave resonator (1) according to any one of the preceding claims, wherein the electrodes $(3, 3_1, 3_2)$ cross-sectionally extend from the upper surface towards the lower surface of the piezoelectric substrate (2).

13. The acoustic wave resonator (1) according to any one of the preceding claims, wherein the electrodes $(3, 3_1, 3_2)$ are formed or partially formed in trenches with a given maximum trench depth, wherein the piezoelectric substrate (2) is characterised with a substrate thickness, and wherein the maximum trench depth to substrate thickness ratio is greater than 0.3, but smaller than 1.

14. An acoustic wave resonator device (15) comprising a plurality of acoustic wave resonators (1) according to any one of the preceding claims electrically interconnected to form a signal filter (15).

15. A method for fabricating an acoustic wave resonator (1), the method comprising:

   - depositing (1) a protection mask (20) on a piezoelectric substrate (2);
   - patterning (2) the protection mask (20);
   - patterning (3) the piezoelectric substrate (2) through the patterned protection mask (20) to create trenches in the piezoelectric substrate (2);
   - depositing (4) an electrode material (3) on the protection mask (20) thereby also filling the trenches;
   - carrying out (5) a photoresist planarization thereby forming a layer of photoresist (21) on the electrode material (3);
   - removing (6, 7) at least the photoresist (21) and excess electrode material by using one more or more etching processes;

   - removing (8) the protection mask (20); and
   - creating (10) a cavity (12) in a base substrate (10) underneath the piezoelectric substrate (2) to thereby suspend a portion of the piezoelectric substrate (2).

Fig. 1

Fig. 2

Fig. 3

Direction
perpendicular
to electrodes

$\varphi = 0°$   SH0 mode

$+\sigma_{xy, max}$

$-\sigma_{xy, max}$

$\varphi = 48°$   S0 mode

$+\sigma_{xx, max}$

$-\sigma_{xx, max}$

Fig. 4

**Fig. 5**

**Fig. 6**

**Fig. 7**

Fig. 8

**Fig. 9**

Fig. 10

Fig. 11

**Fig. 12a**

**Fig. 12b**

$3_2$ $3_1$ $3_2$ $3_1$ $3_2$

$t_s$ $t$ $w$ $\lambda$ $\alpha$ $t_b$ 2

**Fig. 12c**

$3_2$ $3_1$ $3_2$ $3_1$ $3_2$

$t$ $t_m$ $w$ $\lambda$ $\alpha$ $t_b$ 2

**Fig. 12d**

$3_2$ $3_1$ $3_2$ $3_1$ $3_2$

$t_s$ $t$ $w$ $\lambda$ $t_b$ 2

**Fig. 12e**

$3_2$ $3_1$ $3_2$ $3_1$ $3_2$

$t_s$ $t$ $w$ $\lambda$ $t_b$ 2

**Fig. 12f**

**Fig. 13a**

**Fig. 13b**

**Fig. 13c**

1. Hard mask deposition

**Fig. 14a**

2. Hard mask patterning

**Fig. 14b**

3. LiNbO$_3$ patterning

**Fig. 14c**

4. Electrode metal deposition

**Fig. 14d**

## 5. Photoresist planarization

21

20

3

2

10

**Fig. 14e**

## 6. Etch back

20

3

2

10

**Fig. 14f**

## 7. Electrode metal etching

20

3

2

10

**Fig. 14g**

## 8. Hard mask stripping

3

2

10

**Fig. 14h**

9. Release hole patterning

**Fig. 14i**

10. Cavity etching

**Fig. 14j**

Europäisches
Patentamt

European
Patent Office

Office européen
des brevets

## EUROPEAN SEARCH REPORT

**Application Number**

EP 24 19 6553

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/084340 A1 (OUCHI MINEFUMI [JP]) 16 March 2023 (2023-03-16) | 1-6, 10-15 | INV. H03H9/02 |
| Y | * paragraph [0051] - paragraph [0085]; figures 1, 2 * * paragraph [0107] - paragraph [0111] * * paragraph [0008] * | 7-9 | H03H9/13 H03H9/17 H03H3/02 |
| | ----- | | |
| X | US 2022/224305 A1 (KIMURA TETSUYA [JP] ET AL) 14 July 2022 (2022-07-14) | 1-6,12, 14,15 | |
| Y | * paragraph [0137] - paragraph [0158]; figure 26 * * paragraph [0074] - paragraph [0095] * * paragraph [0107] * | 7-9 | |
| | ----- | | |
| A | ZOU JIE ET AL: "Ultra-Large-Coupling and Spurious-Free SH0 Plate Acoustic Wave Resonators Based on Thin LiNbO3", IEEE TRANSACTIONS ON ULTRASONICS, FERROELECTRICS, AND FREQUENCY CONTROL, IEEE, USA, vol. 67, no. 2, 26 September 2019 (2019-09-26), pages 374-386, XP011768268, ISSN: 0885-3010, DOI: 10.1109/TUFFC.2019.2944302 [retrieved on 2020-01-23] * Section V; page 384 * | 4-6 | TECHNICAL FIELDS SEARCHED (IPC) H03H |
| | ----- | | |
| | -/-- | | |

The present search report has been drawn up for all claims

| Place of search | Date of completion of the search | Examiner |
|---|---|---|
| Munich | 20 February 2025 | Schnabel, Florian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................................................

& : member of the same patent family, corresponding document

EPO FORM 1503 03.82 (P04C01)

Europäisches
Patentamt

European
Patent Office

Office européen
des brevets

## EUROPEAN SEARCH REPORT

**Application Number**

EP 24 19 6553

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | STETTLER SILVAN ET AL: "Transversal Spurious Mode Suppression in Ultra-Large-Coupling SH0 Acoustic Resonators on YX36?-Cut Lithium Niobate", 30 June 2023 (2023-06-30), JOURNAL OF MICROELECTROMECHANICAL SYSTEMS, IEEE SERVICE CENTER, US, PAGE(S) 279 - 289, XP011941730, ISSN: 1057-7157 [retrieved on 2023-03-30] * page 281, column 1, last paragraph * | 4-6 | |
| Y | US 2022/337220 A1 (BALLANDRAS SYLVAIN [FR] ET AL) 20 October 2022 (2022-10-20) * figure 4 * | 7-9 | |
| Y | US 2024/178814 A1 (GOTO REI [JP] ET AL) 30 May 2024 (2024-05-30) * figure 7A * | 7-9 | |
| Y | KADOTA MICHIO ET AL: "2-8 GHz Range High Harmonic SAW Resonator with Grooved Electrodes in LiNbO3", 2021 IEEE INTERNATIONAL ULTRASONICS SYMPOSIUM (IUS), IEEE, 11 September 2021 (2021-09-11), pages 1-4, XP034018476, DOI: 10.1109/IUS52206.2021.9593579 [retrieved on 2021-10-28] * figure 4 * | 7-9 | **TECHNICAL FIELDS SEARCHED (IPC)** |

The present search report has been drawn up for all claims

| Place of search | Date of completion of the search | Examiner |
|---|---|---|
| Munich | 20 February 2025 | Schnabel, Florian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.........................................................................

& : member of the same patent family, corresponding document

EPO FORM 1503 03.82 (P04C01)

# EP 4 704 341 A1

## ANNEX TO THE EUROPEAN SEARCH REPORT
## ON EUROPEAN PATENT APPLICATION NO.

EP 24 19 6553

This annex lists the patent family members relating to the patent documents cited in the above-mentioned European search report.
The members are as contained in the European Patent Office EDP file on
The European Patent Office is in no way liable for these particulars which are merely given for the purpose of information.

20-02-2025

| Patent document cited in search report | Publication date | Patent family member(s) | Publication date |
|---|---|---|---|
| US 2023084340 A1 | 16-03-2023 | US 2023084340 A1 | 16-03-2023 |
| | | WO 2021246447 A1 | 09-12-2021 |
| US 2022224305 A1 | 14-07-2022 | CN 114467257 A | 10-05-2022 |
| | | US 2022224305 A1 | 14-07-2022 |
| | | WO 2021060507 A1 | 01-04-2021 |
| US 2022337220 A1 | 20-10-2022 | CN 114342256 A | 12-04-2022 |
| | | CN 114342257 A | 12-04-2022 |
| | | EP 4032183 A2 | 27-07-2022 |
| | | EP 4032184 A2 | 27-07-2022 |
| | | JP 7500913 B2 | 18-06-2024 |
| | | JP 7546656 B2 | 06-09-2024 |
| | | JP 2022548348 A | 18-11-2022 |
| | | JP 2022548490 A | 21-11-2022 |
| | | JP 2024051091 A | 10-04-2024 |
| | | KR 20220056878 A | 06-05-2022 |
| | | KR 20220062407 A | 16-05-2022 |
| | | TW 202119756 A | 16-05-2021 |
| | | TW 202125972 A | 01-07-2021 |
| | | US 2022337220 A1 | 20-10-2022 |
| | | US 2022407491 A1 | 22-12-2022 |
| | | WO 2021053399 A2 | 25-03-2021 |
| | | WO 2021053401 A2 | 25-03-2021 |
| US 2024178814 A1 | 30-05-2024 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9929717 B2